# EUROPEAN PATENT SPECIFICATION

(11) **EP 4 380 051 B1**
(45) Date of publication and mention of the grant of the patent: **30.09.2026**
(21) Application number: 22210140.4
(22) Date of filing: 29.11.2022
(51) Int. Cl.: H03K 17/06, H03K 17/687

(54) **DRIVE VOLTAGE GENERATOR**
ANTRIEBSSPANNUNGSGENERATOR
GÉNÉRATEUR DE TENSION DE COMMANDE

(43) Date of publication of application: 05.06.2024
(73) Proprietor: Nexperia B.V., 6534 AB Nijmegen (NL); Nexperia Technology (Shanghai) Ltd., Shanghai 200025 (CN)
(72) Inventor: Mweene, Loveday Haachitaba, Dallas (US)
(74) Representative: Pjanovic, Ilija

(56) References cited:
- US-B2- 10 361 698
- US-B2- 11 482 918
- US-B2- 7 659 754
- US-B2- 9 742 388
- ZHOU HANG ET AL: "A Gate Driver with a Negative Turn Off Bias Voltage for GaN HEMTs", 2020 IEEE 9TH INTERNATIONAL POWER ELECTRONICS AND MOTION CONTROL CONFERENCE (IPEMC2020-ECCE ASIA), IEEE, 29 November 2020 (2020-11-29), pages 1083 - 1086, XP033883246, DOI: 10.1109/IPEMC-ECCEASIA48364.2020.9367669

## Description

### FIELD

The present disclosure relates to a drive voltage generator for driving an gallium nitride GaN high electron mobility transistor HEMT. In particular, it relates to a drive voltage generator able to take an input square wave and translate the low voltage to a negative voltage, and translate the high voltage to a higher voltage.

### BACKGROUND

It is known in the field of power electronics that enhancement mode GaN (also referred to as eGaN) HEMT is a power switch technology that is promising as a replacement for silicon and silicon carbine MOSFETs in some applications. E-mode GaN HEMTs may enable faster switching and better efficiency in many applications, leading to the development of smaller systems.

Compared to silicon technologies, E-mode GaN HEMT may have a low threshold voltage (e.g. of about 1V) at which a current > 1 - 10 mA starts flowing. Silicon MOSFETs in contrast, may have a threshold voltage in a range of 3V to 5V. Furthermore, the gate to source (or gate-source) voltage at which a GaN HEMT is fully conductive (e.g. typically 5V - 6V) may be high compared to the supply voltages which are available in systems where eGaN HEMTs are being used. As a result, it may be challenging to drive a GaN with a standard power line, such as a 0 - 3.3V supply used to power a 3.3V microcontroller. Providing separate power rails to drive the eGaN HEMT is possible, but can add significant cost and complexity to the system.

It is an object of the present invention to overcome or mitigate a problem associated with the prior art.

In *"*A gate Driver with a Negative Turn Off Bias Voltage for GaN HEMTs" Hang Zhou *et al.* describe a negative turn-off bias generator with a charge pump based approach, offering a stable negative turn-off voltage under different switching frequencies and duty cycles. US10361698B2 describes a gate drive circuit for generating asymmetric drive voltages with a gate driver transformer.

### SUMMARY

According to a first aspect of the present invention, there is provided a drive voltage generator for driving a GaN high electron mobility transistor. The drive voltage generator comprises a fixed input configured to receive fixed voltage, and a square wave input configured to receive a square wave voltage alternating between a high voltage and a low voltage. The drive voltage generator further comprises a first capacitor connected to the square wave input, a first circuit connected to the fixed input, and a first transistor connected to the first capacitor and the first circuit. The drive voltage generator further comprises a second capacitor connected to the square wave input, a second circuit connected the fixed input, and a second transistor connected to the second capacitor and the second circuit. The generator is configured to, when the square wave voltage is low, load, by the first circuit, the first capacitor with a portion of the fixed voltage, and keep, by the first circuit, a gate-source voltage of the first transistor below a first threshold voltage of the first transistor.

When the square wave voltage is high, the generator adds the high voltage to the portion of the fixed voltage of the first capacitor, and increase the gate-source voltage of the first transistor above the first threshold voltage, such that the high voltage and the portion of the fixed voltage of the first capacitor is provided through the transistor as an output voltage of the drive voltage generator. When the square wave voltage is high, the second circuit loads the second capacitor with a portion of the high voltage. The second circuit keeps a gate-source voltage of the second transistor below a second threshold voltage of the first transistor. When the square wave voltage is low, the generator reduces the load of the second capacitor by the high voltage such that it becomes a negative voltage, and increases the gate-source voltage of the second transistor above the second threshold voltage, such that the negative voltage of the second capacitor is provided through the second transistor as an output voltage of the drive voltage generator.

Optionally, the high voltage may be 3.3V and the low voltage may be 0V.

Optionally, the output voltage may be in a range from 4.5V to 6.6V when the square wave voltage is high.

Optionally, the output voltage may be in a range from 5V to 6.6V.

Optionally, the output voltage may be in a range of -1.5V to -3.3V when the square wave voltage is low.

Optionally, the output voltage may be in a range from -2V to -3V.

Optionally, the first circuit may comprise a series connection of a regular diode and a Zener diode connected to the fixed voltage.

Optionally, the second circuit may comprise a series connection of a regular diode and a Zener diode connected to a ground.

Optionally, the square wave voltage may be provided by a microcontroller.

Optionally, the first and second transistors may be bipolar junction transistors. The gate-source voltage may be a base-emitter voltage.

According to another aspect of the current disclosure there is provided a GaN high electron mobility transistor unit comprising a GaN high electron mobility transistor, and a drive voltage generator as described above connected to the GaN high electron mobility transistor. The output voltage of the drive voltage generator may be a supply voltage to the GaN high electron mobility transistor.

According to another aspect of the current disclosure there is provided a method for generating a drive voltage for a GaN high electron mobility transistor. A fixed voltage is received. A square wave voltage alternating between a high voltage and a low voltage is received. When the square wave voltage is low a first circuit connected to a first capacitor loads (charges) the first capacitor with a portion of the fixed voltage. The first circuit keeps a gate-source voltage of a first transistor connected to the first capacitor and the first circuit below a first threshold voltage of the first transistor. When the square wave voltage is high, the high voltage is added to the portion of the fixed voltage of the first capacitor, and the gate-source voltage of the first transistor is increased above the first threshold voltage, such that the high voltage and the portion of the fixed voltage of the first capacitor is provided through the transistor as an output voltage of the drive voltage generator. Further, when the square wave voltage is high a second circuit loads (charges) a second capacitor connected to the second circuit with a portion of the high voltage. The second circuit keeps a gate-source voltage of a second transistor connected to the second capacitor and the second circuit below a second threshold voltage of the second transistor. When the square wave voltage is low the load of the second capacitor is reduced by the high voltage such that it becomes a negative voltage. The gate-source voltage of the second transistor is increased above the second threshold voltage, such that the negative voltage of the second capacitor is provided through the second transistor as an output voltage of the drive voltage generator.

Features of different aspects of the invention may be combined together.

### BRIEF DESCRIPTION OF THE DRAWINGS

Embodiments of the invention will now be described, by way of example only, with reference to the accompanying schematic drawings, in which:
- Figure 1 schematically depicts a drive voltage generator circuit;
- Figure 2 schematically depicts a drive voltage generator connected to a microcontroller and a GaN transistor;
- Figure 3 schematically depicts a specific implementation of a drive voltage generator circuit; and
- Figure 4 depicts a flow diagram of a method for generating a drive voltage for a GaN high electron mobility transistor.

### DETAILED DESCRIPTION

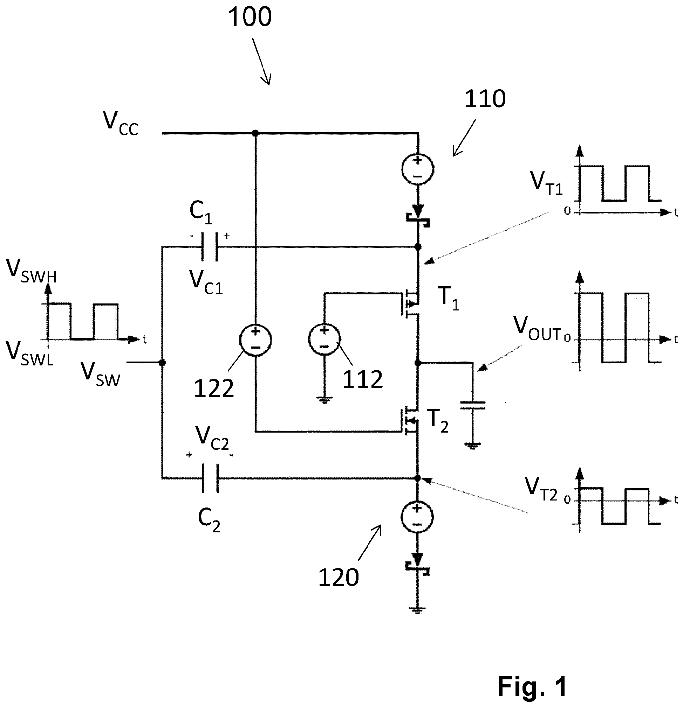

Figure 1 schematically depicts a drive voltage generator 100 circuit. The drive voltage generator may be for providing a drive voltage for a gallium nitride GaN high electron mobility transistor HEMT. The drive voltage generator may provide a drive voltage for a GaN HEMT as an output voltage V_{OUT}. The drive voltage generator 100 may receive as input a fixed input V_{CC}. The input voltage may be a fixed DC voltage V_{CC}. The drive voltage generator 100 may further receive as input a square wave voltage V_{SW}. The square wave voltage may be a voltage provided by a pulse width modulator. The square wave voltage may switch/alternate between a high voltage V_{SWH} and a low voltage V_{SWL}.

A first capacitor C₁ is provided connected to the square wave input V_{SW}. The first capacitor C₁ may be referred to as a positive capacitor, as the aim of the circuit 100 is to charge it to a voltage that is higher than the high voltage of the square wave input V_{SWH}. This may be a voltage that helps increase the high value of V_{OUT} from V_{SWH} to a positive value greater than V_{CC}. The first capacitor C₁ is further connected to a first circuit 110. The first circuit 110 may be referred to as the positive circuit. The first circuit 110 is connected to the fixed input V_{CC}. The first circuit may be designed to have a desired fixed voltage across it when V_{SW} is in the high state. The desired fixed voltage across the first circuit 110 may be referred to as V₁₁₀, and may be such that ${V}_{110} = {V}_{CC} - {V}_{C 1} .$ V_{C1} may be such that ${V}_{C 1} + {V}_{SWH} = {V}_{OUT}$ wherein V_{OUT} may be in a range of > 3.3V to 6.6V, as explained below).

A first transistor T₁ is connected to the first circuit 110 and to the first capacitor C₁. The first transistor may be a MOSFET. The first transistor T₁ may be a p-type MOSFET. The first circuit 110 is depicted in figure 1 as comprising several elements, and may refer to a one or more elements in the circuit used to manage the voltages provided to the different ports of the first transistor T₁.

A second capacitor C₂ is provided connected to the square wave input V_{SW}. The second capacitor C₂ may be referred to as a negative capacitor, as the aim of the circuit 100 is to load it with a voltage that helps to shift the low value of V_{OUT} from zero to a desired negative value. The second capacitor C₂ is further connected to a second circuit 120. The second circuit may be referred to as the negative circuit. The second circuit 120 may be connected (directly or indirectly) to the fixed power supply V_{CC}. A second transistor T₂ is connected to the second circuit 120 and to the second capacitor C₂. The second transistor may be a MOSFET. The second transistor T₂ may be an n-type MOSFET. The second circuit 120 is depicted in figure 1 as comprising several elements, and may refer to a one or more elements in the circuit used to manage the voltages provided to the different ports of the first transistor T₂.

The first transistor T₁ is configured to provide the peak value of the voltage V_{T1} to the output V_{OUT} when the gate of the first transistor T₁ turns the transistor on, such that V_{OUT} is connected to a positive end of C₁. This occurs when the square wave input V_{SW} is in the high state V_{SWH}. The voltage provided as V_{T1} is higher than the high voltage V_{SWH} provided as square wave input. It achieves this as follows: when the square wave V_{SW} voltage is low, V_{CC} and first circuit 110 charge the capacitor C₁ to a voltage of V_{C1}. When V_{SW} goes high to V_{SWH}, the voltage V_{T1} becomes substantially equal to the sum of V_{C1} and V_{SWH}. This may be equal to the desired gate voltage. Element/circuit 112 may have a voltage that is such that it allows T₁ to turn on when V_{SW} is high. Circuit 112 may further be configured such that it forces transistor T₁ to turn off when V_{SW} is low. The portion of the fixed voltage loaded onto the first capacitor V_{C1} may be referred to as positive voltage V_{POS}. When the square wave input is low V_{SWL}, the first circuit 110 may further manage that a voltage between the gate and the source (gate-source voltage V_{GS1}) of the first transistor is lower than a threshold voltage for turning T₁ on.

The second transistor T₂ is configured to provide a voltage V_{T2} to the output V_{OUT} when the gate of the second transistor T₂ turns it on, such that a source voltage of the low value of V_{T2} is connected to the output voltage V_{OUT}. This occurs when the square wave input V_{SW} is in the low state V_{SWL}. The voltage provided as V_{T2} may be generated as follows: capacitor C₂ may be configured to store a voltage. While V_{SW} is high, the capacitor C₂ may charge to a voltage V_{C2} wherein ${V}_{C 2} = {V}_{SWH} - {V}_{120} ,$ with V₁₂₀ being a portion of the voltage loaded over the second circuit 120. When V_{SW} goes low the left hand side of C₂ is brought to 0V potential. Therefore, the right hand side is brought to a voltage of -V_{C2} (equal to -V₁₂₀). This may be loaded as the gate voltage that applies to V_{OUT}.

As V_{SWL} is 0 in many implementations, this means V_{T2} provided to V_{OUT} is a negative voltage. The generator 100 achieves this by, when the square wave voltage is high, having the second circuit 120 connect a portion of the fixed voltage V_{CC} to the gate of T₂. The high voltage V_{SWH} is also connected to the second capacitor C₂. The second circuit 120 further reduces the voltage stored onto second capacitor C₂ to be less than V_{SWH}. The portion of the high voltage V_{SWH} loaded onto the second capacitor V_{C2} may be referred to as negative voltage V_{NEG}. Note that V_{NEG} may be a positive voltage (e.g. V_{SWH} - V₁₂₀, as described above). When the square wave input is high V_{SWH}, the second circuit 120 may further manage that a voltage between the gate and the source (gate-source voltage V_{GS2}) of the second transistor T₂ is lower than a threshold voltage for turning T₂ on.

When the square wave input V_{SW} switches to its low voltage state, the voltage difference (V_{SWH}-V_{SWL}) is subtracted from the voltage loaded onto the second capacitor C₂, loaded onto the second capacitor during the low voltage state. As the subtracted voltage amount is larger than the voltage stored on second capacitor during the high voltage state, the resulting voltage stored on second capacitor is negative: -V_{C2}. The second circuit 120 may be configured to provide this voltage -V_{C2} to the transistor so that V_{T2} = -V_{C2}. The second circuit 120 is also configured to achieve that in response to the square wave input going low, the gate-source voltage V_{GS2} of the first transistor T₂ goes above the threshold voltage, so that T₂ turns on. As a result of T₂ turning on, the voltage V_{T2} is connected to the generator output and provided as V_{OUT}, during the square wave input V_{SW} low state.

In the implementations described herein, V_{CC} may be a DC voltage having a value of 3.3V. Other DC voltage values may be provided. The square wave may switch between 0V and 3.3V. The voltage V_{SW} may be provided by a unipolar rail. The voltage may for example be provided by a microcontroller.

The first capacitor C₁ may draw the first capacitor voltage V_{C1} up to a value in a range from V_{SWH} to twice the value of the high square wave voltage V_{SWH}. In an example where the square wave is a 0 - 3.3V square wave, V_{C1} may be in a range from >3.3V to 6.6V. The first capacitor voltage may preferably be in a range from 5V to 6.6V, or in a range from 5V to 6V. These voltages may be provided as V_{T1}, and as a result as V_{OUT}, while the square wave input state is high. The 5V value may be of interest for turning on a GaN HEMT.

The second capacitor C₂ may draw the second capacitor voltage V_{C2} down from 0 to a negative value -V₁₂₀. In an example where the square wave is a 0 - 3.3V square wave, -V_{C2} may be in a range from <0V to -3.3V. The second capacitor voltage -V_{C2} may preferably be in a range from -2V to -3.3V, or in a range from -2V to -3V. These voltages may be provided as V_{T2}, and as a result as V_{OUT} while the square wave input state is low.

The capacitors C₁ and C₂ may be made large enough in value so that they hold their charge during normal switching operation (e.g. pulse width modulator PWM square wave switching 0 - 3.3V). Large enough may for example be in a range from 10 nF to the order of 1 µF, or higher. During operation, the capacitors C₁ and C₂ hold voltages V_{POS} and -V_{NEG} when the square wave input state is low, and switch to V_{POS}+V_{SWH} and V_{SWH}-V_{NEG} when the square wave input is high.

Element 112 may form part of the first circuit 110 for controlling and directing the voltage on first capacitor C₁ and first transistor T₁. Element 112 may bias the first transistor to be off while the square wave input state is low. Element 122 may form part of the second circuit 120 for controlling and directing the voltage on the second capacitor C₂ and the second transistor T₂. Element 122 may bias the second transistor to be off while to square wave input state is high. When the square wave output is high, the voltage applied to the gate of transistor T₁ may be greater than its threshold voltage, and the first transistor T₁ may be turned on; the gate voltage of transistor T₂ may be less than its threshold voltage, turning the second transistor T₂ off. When the square wave output is low, the voltage applied to the gate of T₂ may be greater than its threshold voltage, and the second transistor T₂ may be turned on; the gate voltage of the first transistor may be less than its threshold voltage, turning the first transistor T₁ off.

GaN or eGaN (enhancement GaN) high electron mobility transistors (HEMTs) are power switching devices which may have significant speed, efficiency, and/or size advantages over their silicon counterparts in switching power supplies. The terminal arrangement and drive requirements of GaN HEMTs may be similar to those of silicon. A challenge with (e)GaN HEMTs is that they may require a low, tightly controlled voltage from 5V to 6V to turn on completely. Their gate threshold voltage meanwhile may be low from around 1V - 2V. The low threshold voltage compared to silicon transistors means GaN HEMTs may be susceptible to unwanted noise, that may turn the transistor on and off. Furthermore, GaN HEMTs may frequently be applied in systems where their gate drive signal originates from a standard electronics components (e.g. from a microcontroller). These standard electronic components often provide an output voltage of 3.3V or less, which is not high enough to turn them on.

A problem of low threshold voltage may be solved by making the off-state voltage of the HEMT negative, rather than zero. That way, the effective threshold voltage may be increased; e.g. instead of a 1V threshold voltage (between 0V to 1V), a 3V threshold voltage (between -2V and 1V). A problem of the 3.3V high state voltage being too low to fully turn on a GaN HEMT may be solved by feeding standard electronic output component output into a separate driver that powers the HEMT. To generate outputs of 5V, and say, -2V, such a driver may require two rails to generate these (negative and higher positive) voltages. This solution of providing additional power rails may add significant cost and complexity to the system.

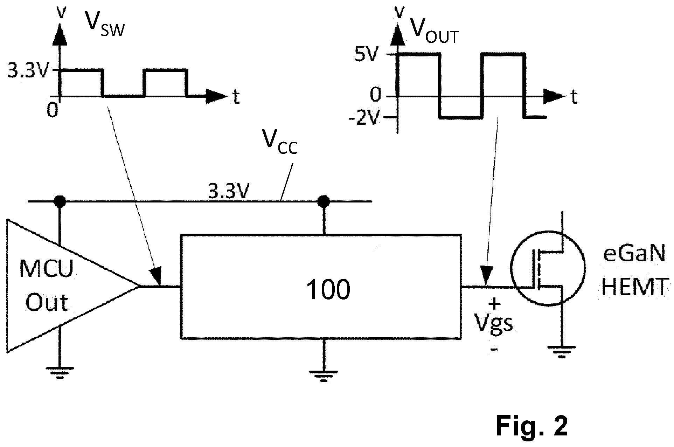

The drive voltage generator described here provides a technique to generate a gate drive signal with an on-state voltage greater than 3.3V (e.g., 5V - 6V), and a negative off-state voltage (e.g., -2V - -3V) without the use or need of any supply rails other than the 3.3V square wave signal. This technique is presented here in its MOSFET implementation, but a bipolar BJT equivalent has also been shown to function equivalently. Figure 2 depicts a schematic representation of an application using the drive voltage generator 100 as described in relation to figure 1. A microcontroller MCU may provide a 0 - 3.3 V square wave output signal. A 3.3V DC rail may be provided as power supply at the microcontroller MCU. The microcontroller output signal may be the square wave signal V_{SW}. The fixed voltage V_{CC} may be provided from the same power supply rail of the microcontroller. V_{SW} and V_{CC} signals may be provided to the drive voltage generator 100 to be translated into a -2V to 5V signal with a square wave shape substantially corresponding to the square wave of the square wave signal. The output signal of generator 100 V_{OUT} may be provided as a drive signal for an eGaN HEMT.

Advantages of the solution using a generator as described in relation to figure 1 may be that the circuit may be made entirely of passive components and discrete semiconductors. Generator 100 may increase the positive swing of the square wave signal VSW from 3.3 V to 5V without changing the waveform shape, and without introducing delays. Generator 100 may change the low state voltage from 0 V to -2V. Generator 100 may accomplish both of these things using only the existing 3.3V microcontroller power rail and the output signal of the microcontroller rail.

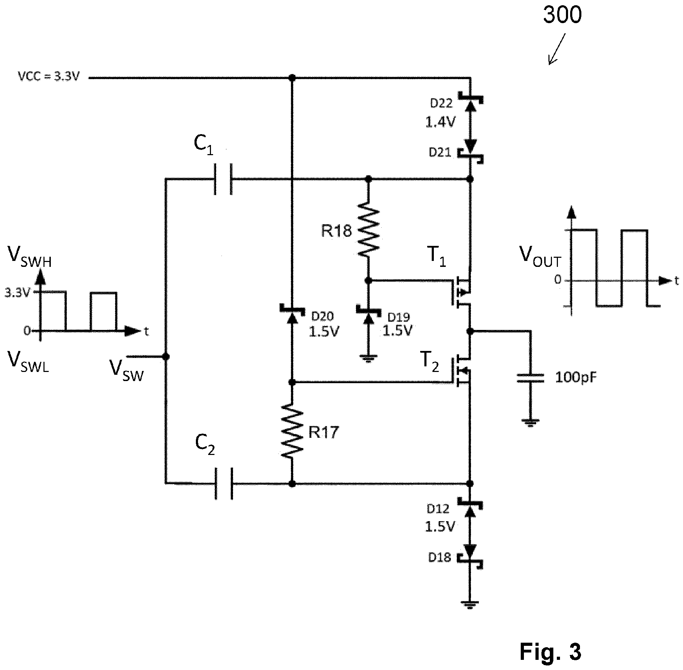

A specific implementation of a drive voltage generator 300 is shown in figure 3. The labels may correspond to the labels described in relation to figure 1. The description provided in relation to figure 1 above, applies to the features of figure 3 as well. Specific implementations of the first circuit 110 and the second circuit 120 are depicted. These may include diodes D12, D18, D19, D20, D21, and D22. D12, D19, D20, and D22 may be Zener diodes. D18 and D21 may be regular diodes. D18 and D21 may be Schottky diodes. Capacitors C₁ and C₂ may have a capacitance in a range from 1nF to 1µF. R17 and R18 may for example have values of 1 kΩ.

Capacitor C₁, transistor T₁, resistor R18, and diodes D19, D21, D22 may be referred to as the positive voltage generator circuit. The positive voltage generator circuit may work as follows: when V_{SW} is low (V_{SWL} = 0V), there is a fixed voltage V_{CC} connected to C₁, via diodes D21 and D22. C₁ may have a right hand side (facing towards V_{CC}) positive. The right hand side positive voltage of C₁ may be equal to V_{CC} minus the forward drop of D21 minus the reverse drop of D22. In an example implementation V_{forward}(D21) = 0.3V and Vᵣₑᵥₑᵣₛₑ(D22) = 1.3V; therefore, when V_{SW} is 0V, V_{C1} = 3.3V - 1.3V - 0.3V = 1.7V. In combination with the voltage over D19 (1.5V), the gate-source voltage V_{GS1} over first transistor T₁ is below the threshold for turning on first transistor T₁. D21 may be a Schottky diode.

When V_{SW} goes high (to V_{SWH} = 3.3V), two things happen. The first thing to happen is the voltage on the right hand side of the capacitor increases by the amount V_{SWH}, so that V_{C1} = 1.7V + 3.3V = 5.0V. This can be because the capacitance of C₁ is large enough so that the V_{CC} voltage may remain on C₄ for typical switching frequencies of V_{SW}. The second thing to happen is the gate source voltage V_{GS1} on the first transistor T₁ goes high so that the transistor turns on. The voltage V_{C1} = 5.0V is connected from the source to the drain of T₁ and linked to V_{OUT} of the voltage generator 300. During the time V_{SW} is in the high state, the second transistor T₂ is off because the breakdown voltage of diode D20 keep the gate voltage of T₂ below threshold.

Capacitor C₂, transistor T₂, resistor R17, and diodes D20, D18, and D12 may be referred to as the negative voltage generator circuit. The negative circuit generator circuit may work as follows: when V_{SW} is high (V_{SWH} = 3.3V), the 3.3V is loaded onto the second capacitor C₂, with the left hand side being positive. The voltage across C₂ is therefore V_{SWH} minus the reverse voltage of diode D12 and the forward voltage of diode D18: V_{C2} = V_{SWH} - Vᵣₑᵥₑᵣₛₑ(D12) - V_{forward}(D18). In an example implementation Vᵣₑᵥₑᵣₛₑ(D12) = 1.5V and V_{forward}(D18) = 0.3V; therefore, when V_{SW} = 3.3V, V_{C2} = 3.3V - 1.5V - 0.3V = 1.5V.

When V_{SW} goes to low (V_{SWL} = 0V), D19 keeps the first transistor T₁ gate-source voltage V_{GS} below threshold, so T₁ is off. When V_{SW} goes down to 0V, the source voltage of T₂ is pulled down to -1.5V, turning the gate-source voltage V_{GS} above threshold. Second transistor T₂ is turned on and the negative voltage is transmitted to V_{OUT}.

As described above, first circuit 110 and/or second circuit 120 may comprise a series connection of a Zener diode and a regular diode. The regular diode may alternatively be a Schottky diode. The first circuit 110 may comprise a series connection of a regular diode and a Zener diode connected to the fixed voltage V_{CC}. The second circuit 120 may comprise a series connection of a regular diode and a Zener diode connected to a ground.

It may be noted that the current that is required to be provided to the HEMT gate voltage V_{OUT} may come from the output of a microcontroller logic gate. However, the output current capability of many such devices may be low, and may be unable to switch a GaN HEMT fast enough. In such cases, the switching waveform from the microcontroller may be fed first to a current-boosting driver before being processed by the drive voltage generator described herein. This driver may operate from the V_{CC} 3.3V rail. This driver may also be provided as part of the drive voltage generator, for example on a same or linked integrated circuit.

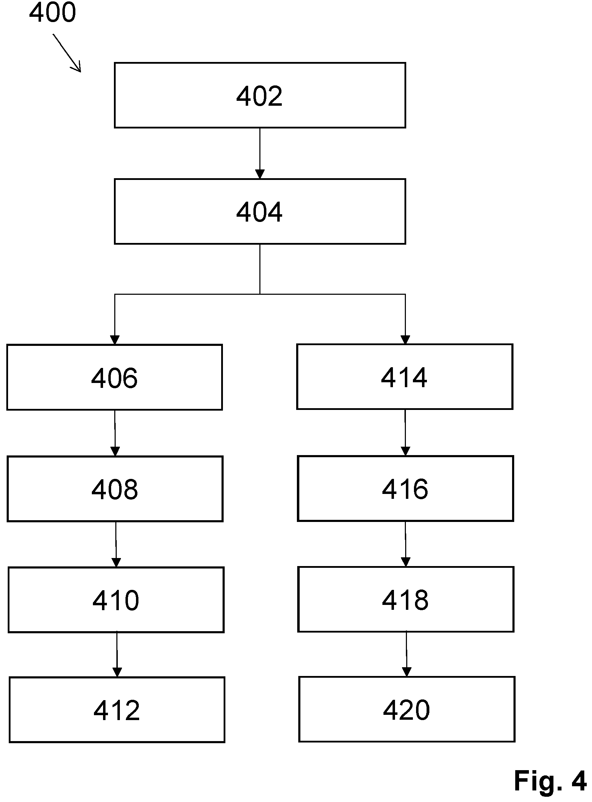

Figure 4 depicts a flow diagram of a method 400 for generating a drive voltage for a GaN high electron mobility transistor. The method comprises receiving 402 a fixed voltage V_{CC}, and receiving 404 a square wave voltage V_{SW} alternating between a high voltage V_{SWH} and a low voltage V_{SWL}. When the square wave voltage is low V_{SWL}: loading 406, by a first circuit 110 connected to a first capacitor C₁, the first capacitor C₁ with a portion of the fixed voltage V_{CC}. The first circuit also keeps 408 a gate-source voltage V_{GS1} of a first transistor T₁ connected to the first capacitor C₁ and the first circuit 110 below a first threshold voltage of the first transistor T₁. When the square wave voltage is high V_{SWH}, the high voltage is added 410 to the portion of the fixed voltage of the first capacitor C₁. The gate-source voltage V_{GS1} of the first transistor T₁ is increased 412 above the first threshold voltage, such that the high voltage and the portion of the fixed voltage of the first capacitor C₁ is provided through the transistor T₁ as an output voltage V_{OUT} of the drive voltage generator.

When the square wave voltage is high, loading 414 by a second circuit 120, a second capacitor C₂ connected to the second circuit 120, with a portion of the high voltage V_{SWH}. The second circuit keeps 416 a gate-source voltage V_{GS2} of a second transistor T₂ connected to the second capacitor C₂ and the second circuit 120 below a second threshold voltage of the second transistor T₂. When the square wave voltage is low, the load of the second capacitor C₂ is reduced 418 by the high voltage such that it becomes a negative voltage. The gate-source voltage of the second transistor is increased 420 above the second threshold voltage, such that the negative voltage of the second capacitor C₂ is provided through the second transistor T₂ as an output voltage of the drive voltage generator.

It should be noted that the specific voltage levels and values mentioned above are for illustration only, and that the methods, circuits, and apparatus described herein may also work at other voltages suitable for specific components needs. Specifically, using the generator circuit 100 described herein the positive voltage may be raised to any desired value up to twice the provided microcontroller rail voltage. The negative voltage may be lowered to any value down to the inverse of the positive rail voltage provided.

Although described herein in relation to MOSFET transistor technology, it is provided that the voltage generators and methods described herein may be implemented for bipolar junction transistors as well using equivalent concepts and solutions as described in relation to MOSFETs.

## Claims

1. A drive voltage generator (100) for driving a GaN high electron mobility transistor, comprising:
a fixed input (V_{cc}) configured to receive a fixed voltage;
a square wave input (V_{SW}) configured to receive a square wave voltage alternating between a high voltage (V_{SWH}) and a low voltage (V_{SWL});
a first capacitor (C₁) connected to the square wave input (V_{SW}), a first circuit (110) connected to the fixed input (V_{SW}), and a first transistor (T₁) connected to the first capacitor (C₁) and the first circuit (110); and
a second capacitor (C₂) connected to the square wave input (V_{SW}), a second circuit (120) connected the fixed input (V_{SW}), and a second transistor (T₂) connected to the second capacitor (C₂) and the second circuit (120);
wherein the generator (100) is configured to,
when the square wave voltage is low, load, by the first circuit (110), the first capacitor (C₁) with a portion of the fixed voltage (V_{cc}), and keep, by the first circuit (110), a gate-source voltage (V_{GS1}) of the first transistor (T₁) below a first threshold voltage of the first transistor (T₁);
and when the square wave voltage is high, add the high voltage to the portion of the fixed voltage of the first capacitor (C₁), and increase the gate-source voltage (V_{GS1}) of the first transistor (T₁) above the first threshold voltage, such that the high voltage and the portion of the fixed voltage of the first capacitor is provided through the transistor as an output voltage (V_{OUT}) of the drive voltage generator (100);
and further configured to,
when the square wave voltage is high, load, by the second circuit (120), the second capacitor (C₂) with a portion of the high voltage, and keep, by the second circuit (120), a gate-source voltage (V_{GS2}) of the second transistor (T₂) below a second threshold voltage of the first transistor;
and when the square wave voltage is low, reduce, by the square wave input (V_{SW}) and the second circuit (120), the load of the second capacitor (C₂) by a difference between the high voltage (V_{SWH}) and the low voltage of the square wave (V_{SWL}) such that the load of the second capacitor (C₂) becomes a negative voltage, and increase the gate-source voltage (V_{GS2}) of the second transistor (T₂) above the second threshold voltage, such that the negative voltage of the second capacitor (C₂) is provided through the second transistor (T₂) as an output voltage (V_{OUT}) of the drive voltage generator (100).

2. A drive voltage generator (1000) according to claim 1, wherein the high voltage is 3.3V and the low voltage is 0V.

3. A drive voltage generator (100) according to claim 2, wherein the output voltage (V_{OUT}) is in a range from 4.5V to 6.6V when the square wave voltage is high (V_{SWH}).

4. A drive voltage generator (100) according to claim 3, wherein the output voltage (V_{OUT}) is in a range from 5V to 6.6V.

5. A drive voltage generator (100) according to any of claims 2 - 4, wherein the output voltage (V_{OUT}) is in a range of -1.5V to -3.3V when the square wave voltage is low (V_{SWL}).

6. A drive voltage generator (100) according to claim 5, wherein the output voltage (V_{OUT}) is in a range from -2V to -3V.

7. A drive voltage generator (100) according to any of the preceding claims, wherein the first circuit (110) comprises a series connection of a regular diode (D₂₁) and a Zener diode (D₂₂) connected to the fixed voltage (V_{CC}).

8. A drive voltage generator (100) according to any of the preceding claims, wherein the second circuit (120) comprises a series connection of a regular diode (D₁₈) and a Zener diode (D₁₂) connected to a ground.

9. A drive voltage generator (100) according to any of the preceding claims, wherein the square wave voltage (V_{SW}) is provided by a microcontroller.

10. A drive voltage generator (100) according to any of the preceding clams, wherein the first (T₁) and second (T₂) transistors are bipolar junction transistors, and wherein the gate-source voltage is a base-emitter voltage.

11. A GaN high electron mobility transistor unit comprising:
a GaN high electron mobility transistor; and
a drive voltage generator (100) according to any of claims 1 - 10 connected to the GaN high electron mobility transistor, and wherein the output voltage (V_{OUT}) of the drive voltage generator is a supply voltage to the GaN high electron mobility transistor.

12. A method (400) for generating a drive voltage for a GaN high electron mobility transistor, comprising:
receiving (402) a fixed voltage;
receiving (404) a square wave voltage alternating between a high voltage and a low voltage;
when the square wave voltage is low:
loading (406), by a first circuit connected to a first capacitor, the first capacitor with a portion of the fixed voltage, and keeping (408), by the first circuit, a gate-source voltage of a first transistor connected to the first capacitor and the first circuit below a first threshold voltage of the first transistor;
and when the square wave voltage is high:
adding (410) the high voltage to the portion of the fixed voltage of the first capacitor, and increasing (412) the gate-source voltage of the first transistor above the first threshold voltage, such that the high voltage and the portion of the fixed voltage of the first capacitor is provided through the transistor as an output voltage of the drive voltage generator;
and further, when the square wave voltage is high
loading (414), by a second circuit, a second capacitor connected to the second circuit, with a portion of the high voltage, and keeping (416), by the second circuit, a gate-source voltage of a second transistor connected to the second capacitor and the second circuit below a second threshold voltage of the second transistor;
and when the square wave voltage is low
reducing (418), by the square wave voltage and the second circuit, the load of the second capacitor by a difference between the high voltage and the low voltage of the square wave such that the load of the second capacitor becomes a negative voltage, and increasing (420) the gate-source voltage of the second transistor above the second threshold voltage, such that the negative voltage of the second capacitor is provided through the second transistor as an output voltage of the drive voltage generator.

## Patentansprüche

1. Ansteuerspannungserzeuger (100) zum Ansteuern eines GaN-High-Electron-Mobility-Transistors, umfassend:
einen Festspannungseingang (V_{CC}), der dazu konfiguriert ist, eine Festspannung aufzunehmen;
einen Rechteckspannungseingang (V_{SW}), der dazu konfiguriert ist, eine zwischen einer hohen Spannung (V_{SWH}) und einer niedrigen Spannung (V_{SWL}) wechselnde Rechteckspannung aufzunehmen;
einen ersten Kondensator (C₁), der mit dem Rechteckspannungseingang (V_{SW}) verbunden ist, einen ersten Schaltkreis (110), der mit dem Festspannungseingang (V_{SW}) verbunden ist, und einen ersten Transistor (T₁), der mit dem ersten Kondensator (C₁) und dem ersten Schaltkreis (110) verbunden ist; und
einen zweiten Kondensator (C₂), der mit dem Rechteckspannungseingang (V_{SW}) verbunden ist, einen zweiten Schaltkreis (120), der mit dem Festspannungseingang (V_{SW}) verbunden ist, und einen zweiten Transistor (T₂), der mit dem zweiten Kondensator (C₂) und dem zweiten Schaltkreis (120) verbunden ist;
wobei der Erzeuger (100) dazu konfiguriert ist,
wenn die Rechteckspannung niedrig ist, durch den ersten Schaltkreis (110) den ersten Kondensator (C₁) mit einem Anteil der Festspannung (V_{CC}) aufzuladen und durch den ersten Schaltkreis (110) eine Gate-Source-Spannung (V_{GS1}) des ersten Transistors (T₁) unter einer ersten Schwellenspannung des ersten Transistors (T₁) zu halten
und, wenn die Rechteckspannung hoch ist, die hohe Spannung zu dem Anteil der Festspannung des ersten Kondensators (C₁) zu addieren und die Gate-Source-Spannung (V_{GS1}) des ersten Transistors (T₁) über die erste Schwellenspannung zu erhöhen, sodass die hohe Spannung und der Anteil der Festspannung des ersten Kondensators durch den Transistor als eine Ausgangsspannung (V_{OUT}) des Ansteuerspannungserzeugers (100) bereitgestellt werden,
und ferner dazu konfiguriert ist,
wenn die Rechteckspannung hoch ist, durch den zweiten Schaltkreis (120) den zweiten Kondensator (C₂) mit einem Anteil der hohen Spannung aufzuladen und durch den zweiten Schaltkreis (120) eine Gate-Source-Spannung (V_{GS2}) des zweiten Transistors (T₂) unter einer zweiten Schwellenspannung des ersten Transistors zu halten
und, wenn die Rechteckspannung niedrig ist, durch den Rechteckspannungseingang (V_{SW}) und den zweiten Schaltkreis (120) die Ladung des zweiten Kondensators (C₂) um eine Differenz zwischen der hohen Spannung (V_{SWH}) und der niedrigen Spannung der Rechteckspannung (V_{SWL}) zu verringern, sodass die Ladung des zweiten Kondensators (C₂) eine negative Spannung wird, und die Gate-Source-Spannung (V_{GS2}) des zweiten Transistors (T₂) über die zweite Schwellenspannung zu erhöhen, sodass die negative Spannung des zweiten Kondensators (C₂) durch den zweiten Transistor (T₂) als eine Ausgangsspannung (V_{OUT}) des Ansteuerspannungserzeugers (100) bereitgestellt wird.

2. Ansteuerspannungserzeuger (1000) nach Anspruch 1, wobei die hohe Spannung 3,3 V und die niedrige Spannung 0 V beträgt.

3. Ansteuerspannungserzeuger (100) nach Anspruch 2, wobei die Ausgangsspannung (V_{OUT}) in einem Bereich von 4,5 V bis 6,6 V liegt, wenn die Rechteckspannung hoch ist (V_{SWH}).

4. Ansteuerspannungserzeuger (100) nach Anspruch 3, wobei die Ausgangsspannung (V_{OUT}) in einem Bereich von 5 V bis 6,6 V liegt.

5. Ansteuerspannungserzeuger (100) nach einem der Ansprüche 2-4, wobei die Ausgangsspannung (V_{OUT}) in einem Bereich von -1,5 V bis -3,3 V liegt, wenn die Rechteckspannung niedrig ist (V_{SWL}).

6. Ansteuerspannungserzeuger (100) nach Anspruch 5, wobei die Ausgangsspannung (V_{OUT}) in einem Bereich von -2 V bis -3 V liegt.

7. Ansteuerspannungserzeuger (100) nach einem der vorhergehenden Ansprüche, wobei der erste Schaltkreis (110) eine Reihenschaltung einer gewöhnlichen Diode (D₂₁) und einer Zener-Diode (D₂₂) umfasst, die mit der Festspannung (V_{CC}) verbunden sind.

8. Ansteuerspannungserzeuger (100) nach einem der vorhergehenden Ansprüche, wobei der zweite Schaltkreis (120) eine Reihenschaltung einer gewöhnlichen Diode (D₁₈) und einer Zener-Diode (D₁₂) umfasst, die mit Masse verbunden sind.

9. Ansteuerspannungserzeuger (100) nach einem der vorhergehenden Ansprüche, wobei die Rechteckspannung (V_{SW}) durch einen Mikrocontroller bereitgestellt wird.

10. Ansteuerspannungserzeuger (100) nach einem der vorhergehenden Ansprüche, wobei der erste (T₁) und der zweite (T₂) Transistor Bipolartransistoren sind und wobei die Gate-Source-Spannung eine Basis-Emitter-Spannung ist.

11. GaN-High-Electron-Mobility-Transistoreinheit, umfassend:
einen GaN-High-Electron-Mobility-Transistor; und
einen Ansteuerspannungserzeuger (100) nach einem der Ansprüche 1-10, der mit dem GaN-High-Electron-Mobility-Transistor verbunden ist, und wobei die Ausgangsspannung (V_{OUT}) des Ansteuerspannungserzeugers eine Versorgungsspannung für den GaN-High-Electron-Mobility-Transistor ist.

12. Verfahren (400) zum Erzeugen einer Ansteuerspannung für einen GaN-High-Electron-Mobility-Transistor, umfassend:
Aufnehmen (402) einer Festspannung;
Aufnehmen (404) einer zwischen einer hohen Spannung und einer niedrigen Spannung wechselnden Rechteckspannung;
wenn die Rechteckspannung niedrig ist,
Aufladen (406), durch einen ersten Schaltkreis, der mit einem ersten Kondensator verbunden ist, des ersten Kondensators mit einem Anteil der Festspannung und Halten (408), durch den ersten Schaltkreis, einer Gate-Source-Spannung eines ersten Transistors, der mit dem ersten Kondensator und dem ersten Schaltkreis verbunden ist, unter einer ersten Schwellenspannung des ersten Transistors;
und, wenn die Rechteckspannung hoch ist,
Addieren (410) der hohen Spannung zu dem Anteil der Festspannung des ersten Kondensators und Erhöhen (412) der Gate-Source-Spannung des ersten Transistors über die erste Schwellenspannung, sodass die hohe Spannung und der Anteil der Festspannung des ersten Kondensators durch den Transistor als eine Ausgangsspannung des Ansteuerspannungserzeugers bereitgestellt werden;
und ferner, wenn die Rechteckspannung hoch ist,
Aufladen (414), durch einen zweiten Schaltkreis, eines zweiten Kondensators, der mit dem zweiten Schaltkreis verbunden ist, mit einem Anteil der hohen Spannung und Halten (416), durch den zweiten Schaltkreis, einer Gate-Source-Spannung eines zweiten Transistors, der mit dem zweiten Kondensator und dem zweiten Schaltkreis verbunden ist, unter einer zweiten Schwellenspannung des zweiten Transistors;
und, wenn die Rechteckspannung niedrig ist,
Verringern (418), durch die Rechteckspannung und den zweiten Schaltkreis, der Ladung des zweiten Kondensators um eine Differenz zwischen der hohen Spannung und der niedrigen Spannung der Rechteckspannung, sodass die Ladung des zweiten Kondensators eine negative Spannung wird, und Erhöhen (420) der Gate-Source-Spannung des zweiten Transistors über die zweite Schwellenspannung, sodass die negative Spannung des zweiten Kondensators durch den zweiten Transistor als eine Ausgangsspannung des Ansteuerspannungserzeugers bereitgestellt wird.

## Revendications

1. Générateur de tension de commande (100) pour commander un transistor à grande mobilité d'électrons GaN, comprenant :
une entrée fixe (V_{CC}) configurée pour recevoir une tension fixe ;
une entrée d'onde carrée (V_{SW}) configurée pour recevoir une tension d'onde carrée alternant entre une tension élevée (V_{SWH}) et une tension basse (V_{SWL}) ;
un premier condensateur (C₁) connecté à l'entrée d'onde carrée (V_{SW}), un premier circuit (110) connecté à l'entrée fixe (V_{SW}) et un premier transistor (T₁) connecté au premier condensateur (C₁) et au premier circuit (110) ; et
un second condensateur (C₂) connecté à l'entrée d'onde carrée (V_{SW}), un second circuit (120) connecté à l'entrée fixe (V_{SW}), et un second transistor (T₂) connecté au second condensateur (C₂) et au second circuit (120) ;
le générateur (100) étant configuré pour :
lorsque la tension d'onde carrée est basse, charger, par le premier circuit (110), le premier condensateur (C₁) avec une partie de la tension fixe (V_{CC}), et maintenir, par le premier circuit (110), une tension grille-source (V_{GS1}) du premier transistor (T₁) en dessous d'une première tension seuil du premier transistor (T₁) ;
et lorsque la tension d'onde carrée est élevée, ajouter la tension élevée à la partie de la tension fixe du premier condensateur (C₁), et augmenter la tension grille-source (V_{GS1}) du premier transistor (T₁) au-dessus de la première tension seuil, de telle sorte que la tension élevée et la partie de la tension fixe du premier condensateur soient fournies par le biais du transistor comme tension de sortie (V_{OUT}) du générateur de tension de commande (100) ;
et configuré en outre pour,
lorsque la tension d'onde carrée est élevée, charger, par le second circuit (120), le second condensateur (C₂) avec une partie de la tension élevée, et maintenir, par le second circuit (120), une tension grille-source (V_{GS2}) du second transistor (T₂) en dessous d'une seconde tension seuil du premier transistor ;
et lorsque la tension d'onde carrée est basse, réduire, par l'entrée d'onde carrée (V_{SW}) et le second circuit (120), la charge du second condensateur (C₂) par une différence entre la tension élevée (V_{SWH}) et la tension basse de l'onde carrée (V_{SWL}) de telle sorte que la charge du second condensateur (C₂) devienne une tension négative, et augmenter la tension grille-source (V_{GS2}) du second transistor (T₂) au-dessus de la seconde tension seuil, de telle sorte que la tension négative du second condensateur (C₂) soit fournie par le biais du second transistor (T₂) comme tension de sortie (V_{OUT}) du générateur de tension de commande (100).

2. Générateur de tension de commande (1000) selon la revendication 1, dans lequel la tension élevée est 3,3 V et la tension basse est 0 V.

3. Générateur de tension de commande (100) selon la revendication 2, dans lequel la tension de sortie (V_{OUT}) est comprise dans une plage de 4,5 V à 6,6 V lorsque la tension d'onde carrée est élevée (V_{SWH}).

4. Générateur de tension de commande (100) selon la revendication 3, dans lequel la tension de sortie (V_{OUT}) est comprise dans une plage de 5 V à 6,6 V.

5. Générateur de tension de commande (100) selon l'une quelconque des revendications 2 à 4, dans lequel la tension de sortie (V_{OUT}) est comprise dans une plage de -1,5 V à -3,3V lorsque la tension d'onde carrée est basse (V_{SWL}).

6. Générateur de tension de commande (100) selon la revendication 5, dans lequel la tension de sortie (V_{OUT}) est comprise dans une plage de -2 V à -3 V.

7. Générateur de tension de commande (100) selon l'une quelconque des revendications précédentes, dans lequel le premier circuit (110) comprend une connexion en série d'une diode régulière (D₂₁) et d'une diode Zener (D₂₂) connectée à la tension fixe (V_{CC}).

8. Générateur de tension de commande (100) selon l'une quelconque des revendications précédentes, dans lequel le second circuit (120) comprend une connexion en série d'une diode régulière (D₁₈) et d'une diode Zener (D₁₂) connectée à une masse.

9. Générateur de tension de commande (100) selon l'une quelconque des revendications précédentes, dans lequel la tension d'onde carrée (V_{SW}) est fournie par un microcontrôleur.

10. Générateur de tension de commande (100) selon l'une quelconque des revendications précédentes, dans lequel les premier (T₁) et second (T₂) transistors sont des transistors à jonction bipolaire, et dans lequel la tension grille-source est une tension base-émetteur.

11. Unité de transistor à grande mobilité d'électrons GaN comprenant :
un transistor à grande mobilité d'électrons GaN ; et
un générateur de tension de commande (100) selon l'une quelconque des revendications 1 à 10 connecté au transistor à grande mobilité d'électrons GaN, et dans laquelle la tension de sortie (V_{OUT}) du générateur de tension de commande est une tension d'alimentation pour le transistor à grande mobilité d'électrons GaN.

12. Procédé (400) de génération d'une tension de commande pour un transistor à grande mobilité d'électrons GaN, comprenant :
la réception (402) d'une tension fixe ;
la réception (404) d'une tension d'onde carrée alternant entre une tension élevée et une tension basse ;
lorsque la tension d'onde carrée est basse :
la charge (406), par un premier circuit connecté à un premier condensateur, du premier condensateur avec une partie de la tension fixe, et le maintien (408), par le premier circuit, d'une tension grille-source du premier transistor connecté au premier condensateur et au premier circuit en dessous d'une première tension seuil du premier transistor ;
et lorsque la tension d'onde carrée est élevée :
l'ajout (410) de la tension élevée à la partie de la tension fixe du premier condensateur, et l'augmentation (412) de la tension grille-source du premier transistor au-dessus de la première tension seuil, de telle sorte que la tension élevée et la partie de la tension fixe du premier condensateur soient fournies par le biais du transistor comme tension de sortie du générateur de tension de commande ;
et en outre lorsque la tension d'onde carrée est élevée :
la charge (414), par un second circuit, d'un second condensateur connecté au second circuit, avec une partie de la tension élevée, et le maintien (416), par le second circuit, d'une tension grille-source du second transistor connecté au second condensateur et au second circuit en dessous d'une seconde tension seuil du second transistor ;
et lorsque la tension d'onde carrée est basse :
la réduction (418), par l'entrée d'onde carrée et le second circuit, de la charge du second condensateur par une différence entre la tension élevée et la tension basse de l'onde carrée de telle sorte que la charge du second condensateur devienne une tension négative, et l'augmentation (420) de la tension grille-source du second transistor au-dessus de la seconde tension seuil, de telle sorte que la tension négative du second condensateur soit fournie par le biais du second transistor comme tension de sortie du générateur de tension de commande.
